# EUROPEAN PATENT APPLICATION

(11) **EP 2 317 703 A1**
(43) Date of publication of application: **04.05.2011**
(21) Application number: 09809182.0
(22) Date of filing: 17.03.2009
(51) Int. Cl.: H04L 12/56

(54) **A PLUG-IN BOX, MACHINE CABINET AND MACHINE ROOM**

(30) Priority: 26.08.2008 CN 200810030389
(71) Applicant: Huawei Technologies Co., Ltd., Longgang District, Shenzhen Guangdong 518129 (CN)
(72) Inventor: CHEN, Haiping c/o Huawei Technologies Co.Ltd., Int.Prop. Dept., Shenzhen (CN)
(74) Representative: Kreuz, Georg Maria
(86) International application number: PCT/CN2009/070822
(87) International publication number: WO 2010/022597

(57) **Abstract**

A subrack is provided. The subrack includes an upper board accommodation area and a lower board accommodation area, and the upper board accommodation area and the lower board accommodation area are adapted to accommodate boards. The lower board accommodation area is sunken to a backplane side of the subrack relative to the upper board accommodation area. A first air inlet is opened at a bottom of the lower board accommodation area, a second air inlet is opened at a bottom of the upper board accommodation area, an air guide frame is set on a top of the subrack, and the air guide frame is in communication with the first air inlet and the second air inlet. A cabinet and a equipment room are provided. It can be seen from the above that the subrack according to the embodiment can improve the heat dissipation effect, thus meeting the heat dissipation requirement of the subrack.

## Description

The present application claims the benefit of priority to China Patent Application No. 200810030389.9, filed on August 26, 2008, and entitled "SUBRACK, CABINET AND EQUIPMENT ROOM", which is incorporated herein by reference in its entirety.

### FIELD OF THE TECHNOLOGY

The present invention relates to the field of communications technology, and more particularly to a subrack, a cabinet, and a equipment roomequipment room.

### BACKGROUND OF THE INVENTION

As the power of a communications device continuously increases, the heat generated during the operation of the communications device also increases. The increase of the heat causes the temperature of the operation environment of electronic components or boards rise. When the temperature of the environment goes higher than that of the electronic components or the boards, the electronic components or the boards cannot operate normally. Therefore, the heat dissipation of communications devices is of great importance.

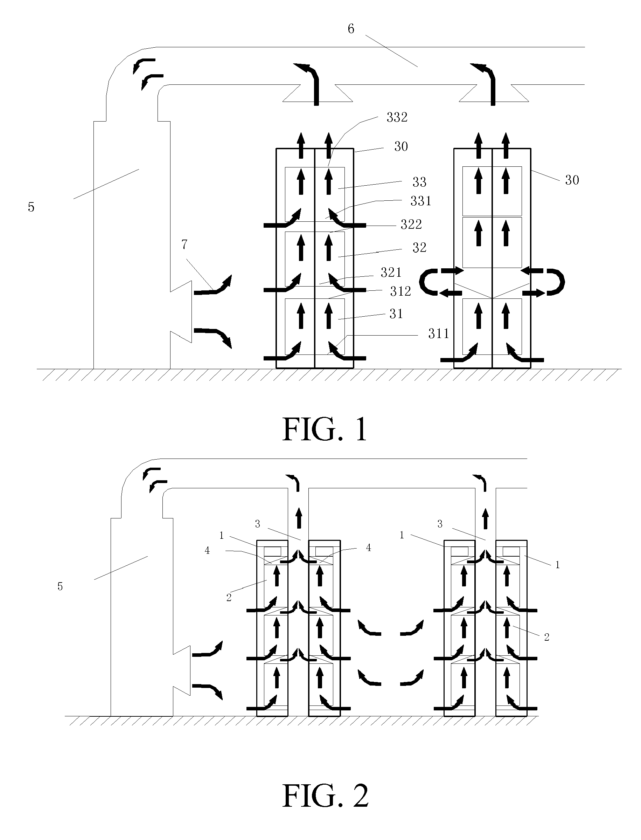

In the prior art, referring to FIG.1, cabinets 30 are set in a equipment room, in which according to the European Telecommunication Standards Institute (ETSI), the cabinets 30 are arranged back to back. A first subrack 31, a second subrack 32 and a third subrack 33 are set in the cabinet 30, and the first subrack 31, the second subrack 32 and the third subrack 33 are vertically stacked. Boards are set in the first subrack 31, the second subrack 32 and the third subrack 33, and components for various services are set on the boards, in which a first air inlet 311 is set at a bottom of the first subrack 31, a first air exhaust vent 312 is set on a top of the first subrack 31, a second air inlet 321 is set at a bottom of the second subrack 32, a second air exhaust vent 322 is set on a top of the second subrack 32, a third air inlet 331 is set at a bottom of the third subrack 33, and a third air exhaust vent 332 is set on a top of the third subrack 33. When the subracks in the cabinet 30 dissipate heat, an air conditioner system 5 in the equipment room generates a cooling air stream 7, which enters the first subrack 31, the second subrack 32 and the third subrack 33 from the first air inlet 311 of the first subrack 31, the second air inlet 321 of the second subrack 32 and the third air inlet 331 of the third subrack 33 respectively, and thus, the components in each subrack are cooled. The air stream from the first subrack 31 enters an air cooling channel 6 after passing through the second subrack 32 and the third subrack 33, and the air stream from the second subrack 32 enters the air cooling channel 6 after passing through the third subrack 33.

During the implementation of the present invention, the inventor finds that the prior art at least has the following problems.

After the cooling air stream 7 generated by the air conditioner system 5 enters the first subrack 31, the air stream that flows through the first subrack 31 passes the second subrack 32 and the third subrack 33. Therefore, the air stream that flows through the first subrack 31 is the heat air stream, and the heat air stream enters the second subrack 32 and the third subrack 33, thus affecting the heat dissipation effect of the second subrack 32 and the third subrack 33.

### SUMMARY OF THE INVENTION

The present invention is directed to a subrack, a cabinet and a equipment room, for solving the heat dissipation problem of the subrack.

The present invention provides a subrack, which includes an upper board accommodation area and a lower board accommodation area, and the upper board accommodation area and the lower board accommodation area are adapted to accommodate boards. The lower board accommodation area is sunken to a backplane side of the subrack relative to the upper board accommodation area. A first air inlet is set at a bottom of the lower board accommodation area, a second air inlet is set at a bottom of the upper board accommodation area, an air guide frame is set on a top of the subrack, and the air guide frame is in communication with the first air inlet and the second air inlet.

The present invention provides a cabinet, in which a subrack is set in the cabinet, the subrack includes an upper board accommodation area and a lower board accommodation area, the upper board accommodation area and the lower board accommodation area are adapted to accommodate boards. The lower board accommodation area is sunken to the backplane side of the subrack relative to the upper board accommodation area. A first air inlet is set at a bottom of the lower board accommodation area, a second air inlet is set at a bottom of the upper board accommodation area, an air guide frame is set on a top of the subrack, and the air guide frame is in communication with the first air inlet and the second air inlet.

The present invention provides a equipment room, which includes an air conditioner system and at least two cabinets. The air conditioner system is adapted to cool the two cabinets, the two cabinets are arranged back to back, and a certain distance is kept between the backs of the cabinets, the space between the backs of the two cabinets forms an air cooling channel. A subrack is set in each of the two cabinets, and an air guide frame is set on the top of the subrack to guide the air stream that flows through the subrack into the air cooling channel.

According to the above technical solution, the air stream flows through the lower board accommodation area via the first air inlet, and the air stream that flows through the lower board accommodation area passes the upper board accommodation area via the second air inlet at the bottom of the upper board accommodation area; meanwhile, the air stream can pass the second air inlet at the bottom of the upper board accommodation area via the sunken space, and flow through the upper board accommodation area. And then the air stream is exported through the air guide frame, thus meeting the heat dissipation requirement of the subrack.

### BRIEF DESCRIPTION OF THE DRAWINGS

FIG. 1 is a schematic view of heat dissipation of cabinets arranged back to back according to the prior art;
FIG. 2 is a schematic structural view of a equipment room according to an embodiment of the present invention;
FIG. 3 is a schematic view of heat dissipation of a subrack set in a cabinet according to an embodiment of the present invention;
FIG. 4 is a schematic structural view of an embodiment of a subrack according the present invention;
FIG. 5 is a schematic structural view of another embodiment of a subrack according to the present invention; and
FIG. 6 is a schematic structural view of another embodiment of a subrack according to the present invention.

### DETAILED DESCRIPTION OF THE EMBODIMENTS

The technical solutions of the present invention will be clearly and fully described below with reference to the accompanying drawings. It is obvious that the embodiments to be described are only a part rather than all of the embodiments of the present invention. All other embodiments derived by persons skilled in the art based on the embodiments of the present invention without creative efforts shall fall within the protection scope of the present invention.

FIG.2 is a schematic structural view of a equipment room according to an embodiment of the present invention. As shown in FIG.2, the equipment room includes an air conditioner system 5 and at least two cabinets 1, and the air conditioner system 5 is adapted to cool the two cabinets 1. The two cabinets 1 are arranged back to back, and a certain distance is kept between the backs of the two cabinets 1, and the space between the backs of the two cabinets 1 forms an air cooling channel 3. An air guide frame 4 is set on the top of a subrack 2 in the two cabinets 1 to guide the air stream that flows through the subrack 2 into the air cooling channel 3.

The back of the cabinet 1 may be understood as: the subrack 2 is put into the cabinet 1 from the front, and the side opposite the front is the back of the cabinet 1.

The distance between the backs of the two cabinets 1 may be 200mm-300mm.

It can be seen from the above that according to the embodiment of the present invention, the air guide frame 4 is set on the top of the subrack 2 in the cabinet 1 in a equipment room, the space between the two cabinets 1 forms the air cooling channel 3, and thus the cooling air stream generated by the air conditioner system 5 can flow through the subrack 2, and the air stream that flows through the subrack 2 is guided into the air cooling channel 3 through the air guide frame 4. In this way, the cooling air stream from the air conditioner system 5 enters the subrack 2 from the bottom of the subrack 2, flows out through the air guide frame 4 on the top of the subrack, and enters the air cooling channel 3, thus meeting the heat dissipation requirement of the subrack 2.

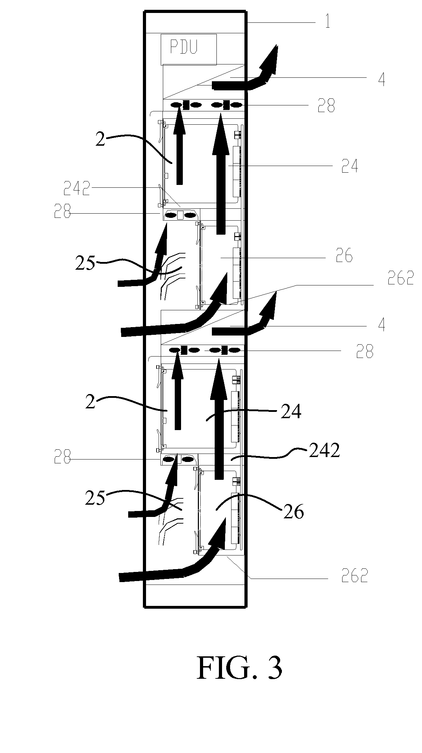

FIG.3 is a schematic structural view of a cabinet 1 according to an embodiment of the present invention. Referring to FIG.3, a subrack 2 is set in the cabinet 1, the subrack 2 includes an upper board accommodation area 24 and a lower board accommodation area 26, the upper board accommodation area 24 and the lower board accommodation area 26 are adapted to accommodate boards, and an air guide frame 4 is set on the top of the subrack 2. The lower board accommodation area 26 is sunken into the backplane side of the subrack relative to the upper board accommodation area 24, thus forming a sunken space 25. A first air inlet 262 is set at a bottom of the lower board accommodation area 26, a second air inlet 242 is set at a bottom of the upper board accommodation area 24, and the air guide frame 4 is in communication with the first air inlet 262 and the second air inlet 242.

It can be seen from the above that the air stream flows into the lower board accommodation area 26 of the subrack 2 via the first air inlet 262, and the air stream that flows through the lower board accommodation area 26 passes the upper board accommodation area 24 via the second air inlet 242 at the bottom of the upper board accommodation area 24; meanwhile, the air stream can pass the second air inlet 242 at the bottom of the upper board accommodation area 24 via the sunken space 25, and flow through the upper board accommodation area 24, and then the air guide frame 4 exports the air stream, thus meeting the heat dissipation requirement of components on the boards of the subrack 2.

The air guide frame 4 being in communication with the first air inlet 262 and the second air inlet 242 may be understood as: the air stream flows through the lower board accommodation area 26 of the subrack 2 via the first air inlet 262,and the air stream that flows through the lower board accommodation area 26 flows through the upper board accommodation area 24 via the second air inlet 242 of the upper board accommodation area 24; meanwhile, the air stream passes the second air inlet 242 at the bottom of the upper board accommodation area 24 via the sunken space 25, and flows through the upper board accommodation area 24, and in this way, the air stream that passes the first air inlet 262 and the second air inlet 242 is exported from the subrack 2 through the air guide frame 4.

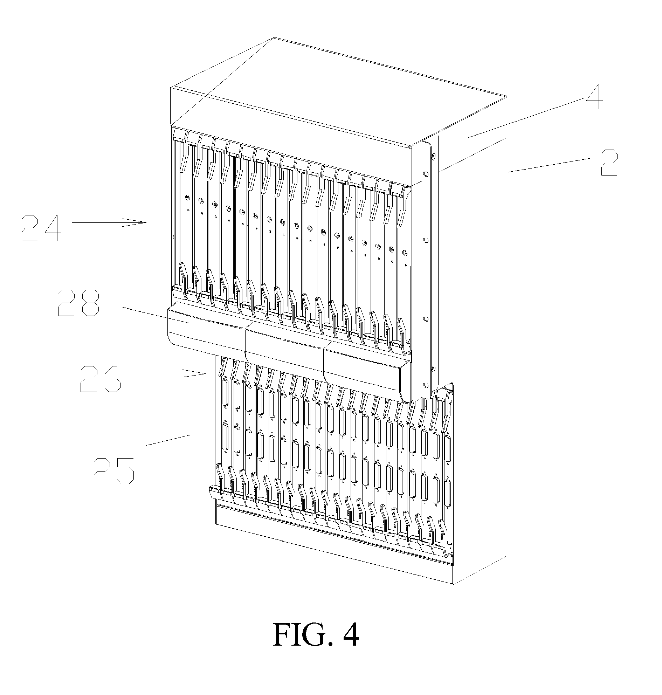

Referring to FIG. 3 and FIG.4, the present invention further provides a subrack. The subrack 2 includes an upper board accommodation area 24 and a lower board accommodation area 26, and the upper board accommodation area 24 and the lower board accommodation area 26 are adapted to accommodate boards. The lower board accommodation area 26 is sunken into a backplane side of the subrack relative to the upper board accommodation area 24. A first air inlet 262 is set at a bottom of the lower board accommodation area 26, a second air inlet 242 is set at a bottom of the upper board accommodation area 24, an air guide frame 4 is set on a top of the subrack 2, and the air guide frame 4 is in communication with the first air inlet 262 and the second air inlet 242.

It can be seen from the above that when the subrack 2 dissipates heat, the air stream flows into the lower board accommodation area 26 of the subrack 2 via the first air inlet 262, and the air stream that flows through the lower board accommodation area 26 passes the upper board accommodation area 24 via the second air inlet 242 at the bottom of the upper board accommodation area 24; meanwhile, the air stream can pass the second air inlet 242 at the bottom of the upper board accommodation area 24 via the sunken space 25, and flows through the upper board accommodation area 24, thus meeting the heat dissipation requirement of components on the boards of the subrack 2.

The air guide frame 4 being in communication with the first air inlet 262 and the second air inlet 242 may be understood as: the air stream flows through the lower board accommodation area 26 of the subrack 2 via the first air inlet 262, and the air stream that flows through the lower board accommodation area 26 flows through the upper board accommodation area 24 via the second air inlet 242 of the upper board accommodation area 24; meanwhile, the air stream passes the second air inlet 242 at the bottom of the upper board accommodation area 24 via the sunken space 25, and flows through the upper board accommodation area 24, and in this way, the air stream that passes the first air inlet 262 and the second air inlet 242 is exported from the subrack 2 through the air guide frame 4.

The backplane side may be understood as: the board is inserted from the front of the subrack, and the side that is opposite to the front of the subrack 2 is the backplane side.

Referring to FIG.4, the lower board accommodation area 26 being sunken into the backplane side of the subrack 2 relative to the upper board accommodation area 24 may be understood as: the boards in the lower board accommodation area 26 are of the same depth and the boards in the upper board accommodation area 24 are of the same depth, in which the depth of the boards in the lower board accommodation area 26 is smaller than that of the boards in the upper board accommodation area 24.

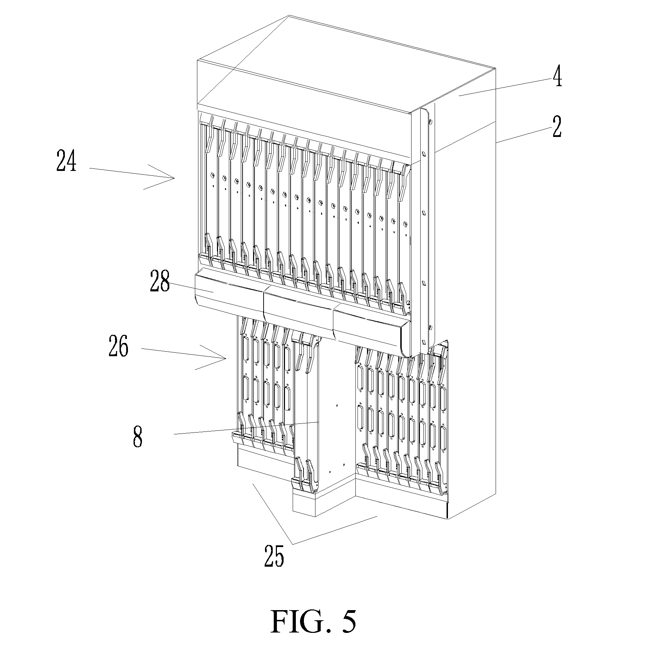

Referring to FIG.5, the lower board accommodation area 26 being sunken into the backplane side of the subrack 2 relative to the upper board accommodation area 24 may be understood as: a board 8 of the boards in the lower board accommodation area 26 is in the same plane with the boards in the upper board accommodation area, and the depth of other boards in the lower board accommodation area 26 is smaller than that of the boards in the upper board accommodation area 24.

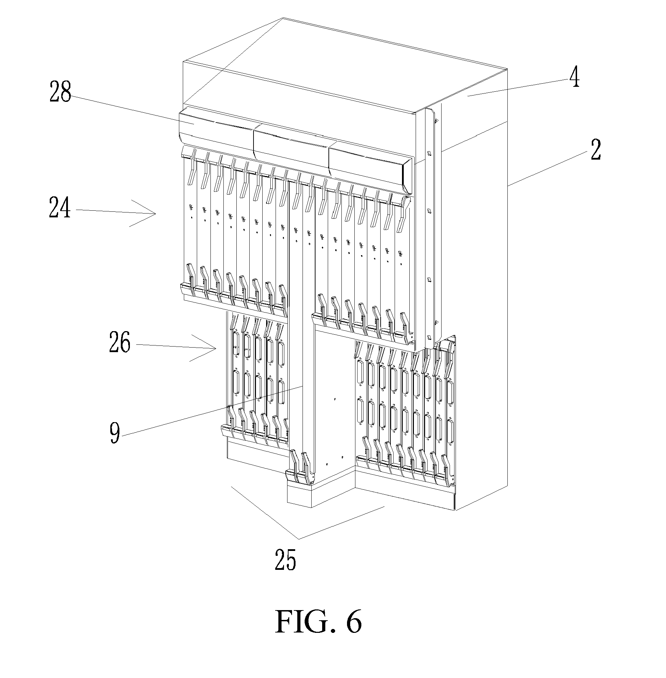

Referring to FIG.6, the lower board accommodation area 26 being sunken into the backplane side of the subrack 2 relative to the upper board accommodation area 24 may be understood as: a board 9 in the subrack 2 is inserted into the upper board accommodation area 24 and the lower board accommodation area 26, and the depth of other boards in the lower board accommodation area 26 is smaller than that of other boards in the upper board accommodation area 24.

It should be noted that the depth of the boards in the lower board accommodation area 26 is the distance from the front side of the boards in the lower board accommodation area 26 to the backplane, that is, the distance from a handle bar of the board to the backplane.

In the same manner, the depth of the boards in the upper board accommodation area 24 is the distance from the front side of the boards in the upper board accommodation area 24 to the backplane, that is, the distance from a handle bar of the board to the backplane.

Referring to FIG.4, the air guide frame 4 being set on the top of the subrack 2 may be understood as: the air guide frame 4 is in the upper board accommodation area 24, that is, the air guide frame 4 and the upper board accommodation area 24 are in an integrated structure, and the subrack 2 includes the air guide frame 4.

The air guide frame 4 being set on the top of the subrack 2 may also be understood as: the air guide frame 4 is located on the upper board accommodation area 24, that is, the air guide frame 4 and the subrack 2 are two independent components, and the air guide frame 4 is set on the top of the subrack 2.

Further, for the subrack 2 in the above embodiment, in order to better meet the heat dissipation requirement of the components in the subrack 2, the boards in the upper board accommodation area 24 of the subrack 2 may be service boards, and the boards in the lower board accommodation area 26 of the subrack 2 may be cable connecting boards. In this way, when the subrack 2 dissipates heat, the cooling air stream can enter the lower board accommodation area 26 of the subrack 2 via the first air inlet 262, and continue to flow upward to the upper board accommodation area 24 of the subrack 2, and meanwhile, the cooling air stream can also enter the upper board accommodation area 24 of the subrack 2 from the second air inlet 242 via the sunken space 25, and then the air stream is exported through the air guide frame 4 on the top of the subrack 2.

It can be seen from the above that the air stream flows into the lower board accommodation area 26 via the first air inlet 262 at the bottom of the lower board accommodation area 26, and then flows through the upper board accommodation area 24 via the second air inlet 242 at the bottom of the upper board accommodation area 24; meanwhile, the air stream can passes the second air inlet 242 at the bottom of the upper board accommodation area 24 via the sunken space 25, and then flows through the upper board accommodation area 24. The boards accommodated in the lower board accommodation area 26 are cable connecting boards, and the air stream that flows through the lower board accommodation area 26 flows into the upper board accommodation area 24 via the second air inlet 242, thus better cooling the board components in the upper board accommodation area 24.

Further, since the boards in the lower board accommodation area 26 are cable connecting boards that consume less energy and generate less heat, and the boards in the upper board accommodation area 24 are service boards, in which the components generate more heat; therefore, the air stream can first cool the boards with small power consumption, and then cool the boards with big power consumption. In this way, the heat generated by the boards with big power consumption does not effect the cooling of the boards with small power consumption, and such setting can improve the cooling effect of the single subrack. Meanwhile, the sunken space 25 is formed because the lower board accommodation area 26 is sunken into the backplane side of the subrack 2 relative to the upper board accommodation area 24, thus enlarging the cable connecting space and making cable connection smoother.

Referring to FIG.3 and FIG.4, a fan frame 28 is further set in the subrack 2 according to the embodiment of the present invention. The fan frame 28 may be set at the bottom of the upper board accommodation area 24 of the subrack 2, and is located at the second air inlet 242. A fan is set in the fan frame 28, and under the action of the fan in the fan frame 28, the air stream flows through the upper board accommodation area 24, thus cooling the boards in the upper board accommodation area 24.

The fan frame 28 may also be set between the upper board accommodation area 24 of the subrack and the air guide frame 4, a fan is set in the fan frame 28, and under the action of the fan in the fan frame 28, the air stream flows through the lower board accommodation area 26 and the upper board accommodation area 24, thus cooling the boards in the lower board accommodation area 26 and the upper board accommodation area 24.

In conclusion, it can be seen from the above that the lower board accommodation area 26 is sunken into the backplane side of the subrack relative to the upper board accommodation area 24, thus forming a sunken space. The air steam enters from the bottom of the upper board accommodation area 24 of the subrack 2 and the bottom of the lower board accommodation area 26 of the subrack 2, and comes out from backplane side at the top of the upper board accommodation area 24 of the subrack 2, thus achieving the air channel design in which the air is taken in from the lower front and exported from the upper back. Meanwhile, such air channel that takes in air from the lower front and exports the air from the upper back can prevent the heat of the subrack in the lower part of the cabinet from being absorbed by the subrack above it, thus not only improving the heat dissipation effect of the single subrack, but also increasing the stability of the cabinet.

It should be understood that the subrack 2 in the above embodiment may be applied in the cabinet 1, and the cabinet 1 having the subrack 2 may be applied in the equipment room. Of course, for the subrack 2 in the cabinet 1 according to the above embodiment, the subrack 2 is not limited to the subrack 2 in the embodiment of the present invention. The subrack that takes in air from the bottom and exports air from the backplane side, or the subrack that takes in air from the lower front and exports air from the backplane side may both be applied in the equipment room according to the embodiment of the present invention.

The above descriptions are merely specific embodiments of the present invention, but not intended to limit the present invention. Any modification or replacement made by persons skilled in the art without departing from technical solutions disclosed in the present invention should fall within the scope of the present invention. Therefore, the scope of the present invention is subject to the scope of the claims.

## Claims

1. A subrack, comprising
an upper board accommodation area and a lower board accommodation area, wherein the upper board accommodation area and the lower board accommodation area are adapted to accommodate boards;
wherein the lower board accommodation area is sunken into a backplane side of the subrack relative to the upper board accommodation area;
a first air inlet is set at a bottom of the lower board accommodation area, a second air inlet is set at a bottom of the upper board accommodation area, an air guide frame is set on a top of the subrack, and the air guide frame is in communication with the first air inlet and second air inlet.

2. The subrack according to claim 1, wherein
the lower board accommodation area being sunken into the backplane side of the subrack relative to the upper board accommodation area comprises: the boards in the lower board accommodation area are of the same depth and the boards in the upper board accommodation area are of the same depth, and the depth of the boards in the lower board accommodation area is smaller than that of the boards in the upper board accommodation area.

3. The subrack according to claim 1, wherein
the lower board accommodation area being sunken into the backplane side of the subrack relative to the upper board accommodation area comprises: a board of the boards in the lower board accommodation area is in the same plane with the boards in the upper board accommodation area, and the depth of other boards in the lower board accommodation area is smaller than that of the boards in the upper board accommodation area.

4. The subrack according to claim 1, wherein
the lower board accommodation area being sunken into the backplane side of the subrack relative to the upper board accommodation area comprises: a board in the subrack is inserted into the upper board accommodation area and the lower board accommodation area, and the depth of other boards in the lower board accommodation area is smaller than that of other boards in the upper board accommodation area.

5. The subrack according to claim 1, further comprising:
a fan frame, wherein a fan is set in the fan frame, the fan frame with the fan is set between the air guide frame and the upper board accommodation area, and/or the fan frame with the fan is set at the bottom of the upper board accommodation area and is located at the second air inlet.

6. The subrack according to claim 1, wherein
the boards in the upper board accommodation area are service boards, and the boards in the lower board accommodation area are cable connecting boards.

7. A cabinet, wherein a subrack is set in the cabinet, and
the subrack comprises an upper board accommodation area and a lower board accommodation area, wherein the upper board accommodation area and the lower board accommodation area are adapted to accommodate boards;
the lower board accommodation area is sunken into a backplane side of the subrack relative to the upper board accommodation area; and
a first air inlet is set at a bottom of the lower board accommodation area, a second air inlet is set at a bottom of the upper board accommodation area, an air guide frame is set on a top of the subrack, and the air guide frame is in communication with the first air inlet and second air inlet.

8. The cabinet according to claim 7, wherein
the subrack further comprises a fan frame, a fan is set in the fan frame, the fan frame with the fan is set between the air guide frame and the upper board accommodation area, and/or the fan frame with the fan is set at the bottom of the upper board accommodation area and is located at the second air inlet.

9. The cabinet according to claim 7, wherein
the boards in the upper board accommodation area are service boards, and the boards in the lower board accommodation area are cable connecting boards.

10. A equipment room, comprising an air conditioner system and at least two cabinets, the air conditioner system being adapted to cool the two cabinets, wherein
the two cabinets are arranged back to back, a certain distance is kept between the backs of the cabinets, the space between the backs of the two cabinets forms an air cooling channel, a subrack is set in each of the two cabinets, an air guide frame is set on a top of the subrack to guide the air stream that flows through the subrack into the air cooling channel.

11. The equipment room according to claim 10, wherein
the subrack comprises an upper board accommodation area and a lower board accommodation area, wherein the upper board accommodation area and the lower board accommodation area are adapted to accommodate boards;
the lower board accommodation area is sunken into a backplane side of the subrack relative to the upper board accommodation area; and
a first air inlet is set at a bottom of the lower board accommodation area, a second air inlet is set at a bottom of the upper board accommodation area, and the air guide frame is set on the top of the upper board accommodation area.

12. The equipment room according to claim 11, wherein
the subrack further comprises a fan frame, a fan is set in the fan frame, the fan frame with the fan is set between the air guide frame and the upper board accommodation area, and/or the fan frame with the fan is set at the bottom of the upper board accommodation area and is located at the second air inlet.

13. The equipment room according to claim 11, wherein
the boards in the upper board accommodation area are service boards, and the boards in the lower board accommodation area are cable connecting boards.
